# EUROPEAN PATENT SPECIFICATION

(11) **EP 3 738 148 B1**
(45) Date of publication and mention of the grant of the patent: **21.10.2026**
(21) Application number: 18837027.4
(22) Date of filing: 19.12.2018
(51) Int. Cl.: H10F 39/12, H10F 39/00, H10F 39/18, H10F 71/00, H10F 77/122, H10F 77/40

(54) **GERMANIUM-MODIFIED, BACK-SIDE ILLUMINATED OPTICAL SENSOR**
GERMANIUMMODIFIZIERTER RÜCKSEITIG BELEUCHTETER OPTISCHER SENSOR
CAPTEUR OPTIQUE RÉTROÉCLAIRÉ MODIFIÉ AU GERMANIUM

(30) Priority: 10.01.2018 US 201862615892 P; 01.05.2018 US 201815968657
(43) Date of publication of application: 18.11.2020
(73) Proprietor: Microsoft Technology Licensing, LLC, Redmond, WA 98052-6399 (US)
(72) Inventor: NAGARAJA, Satyadev Hulikal, Redmond, Washington 98052-6399 (US); AKKAYA, Onur Can, Redmond, Washington 98052-6399 (US); BAMJI, Cyrus Soli, Redmond, Washington 98052-6399 (US)
(74) Representative: CMS Cameron McKenna Nabarro Olswang LLP
(86) International application number: PCT/US2018/066343
(87) International publication number: WO 2019/139751

(56) References cited:
- EP-A1- 3 141 927
- WO-A1-2017/024121
- WO-A1-96/39719
- DE-A1- 102012 213 280
- US-A1- 2007 158 770
- US-A1- 2008 023 738
- US-A1- 2008 121 805
- US-A1- 2013 228 886
- VISHAL A. TIWARI ET AL: "Effects of trap-assisted tunneling on gate-induced drain leakage in silicon-germanium channel p-type FET for scaled supply voltages", JAPANESE JOURNAL OF APPLIED PHYSICS, vol. 55, no. 4S, 2 March 2016 (2016-03-02), JP, pages 04ED03, XP055591485, ISSN: 0021-4922, DOI: 10.7567/JJAP.55.04ED03

## Description

### BACKGROUND

Terrestrial sunlight provides strong irradiance at and around 850 nanometers (nm), where state-of-the-art near-infrared (NIR) sensors typically operate. Some forms of artificial room lighting also provide significant irradiance in this range. Accordingly, ambient irradiance, especially from sunlight, may provide an undesirably large background for various NIR sensor applications.
US 2013/228886 A1 describes methods and apparatus for a backside illuminated (BSI) image sensor device. A BSI sensor device is formed on a substrate comprising a photosensitive diode. The substrate may be thinned at the backside, then a B doped Epi-Si(Ge) layer may be formed on the backside surface of the substrate. Additional layers may be formed on the B doped Epi-Si(Ge) layer, such as a metal shield layer, a dielectric layer, a micro-lens, and a color filter.
US 2008/121805 A1 describes a germanium (Ge) short wavelength infrared (SWIR) imager and associated fabrication process. The imager comprises a silicon (Si) substrate with doped wells. An array of pin diodes is formed in a relaxed Ge-containing film overlying the Si substrate, each pin diode having a flip-chip interface. There is a Ge/Si interface, and a doped Ge-containing buffer interposed between the Ge-containing film and the Ge/Si interface. An array of Si CMOS readout circuits is bonded to the flip-chip interfaces. Each readout circuit has a zero volt diode bias interface.
WO 2017/24121A1 describes an image sensor array including a carrier substrate; a first group of photodiodes coupled to the carrier substrate, where the first group of photodiodes include a first photodiode, and where the first photodiode includes a semiconductor layer configured to absorb photons at visible wavelengths and to generate photo-carriers from the absorbed photons; and a second group of photodiodes coupled to the carrier substrate, where the second group of photodiodes include a second photodiode, and where the second photodiode includes a germanium-silicon region fabricated on the semiconductor layer, the germanium-silicon region configured to absorb photons at infrared or near-infrared wavelengths and to generate photo-carriers from the absorbed photons.
VISHAL A. TIWARI ET AL, "Effects of trap-assisted tunneling on gate-induced drain leakage in silicon-germanium channel p-type FET for scaled supply voltages" describes silicon-germanium considered as an alternative channel material to silicon p-type FET (pFET) for the development of energy efficient high performance transistors for 28 nm and beyond in a high-k metal gate technology because of its lower threshold voltage and higher mobility. However, gate-induced drain leakage (GIDL) is a concern for high threshold voltage device design because of tunneling at reduced bandgap. In this work, the trap-assisted tunneling and band-to-band tunneling (BTBT) effects on GIDL is analyzed and modeled for SiGe pFETs. Experimental results and Monte Carlo simulation results reveal that the pre-halo germanium pre-amorphization implant used to contain the short channel effects contribute to GIDL at the drain sidewall in addition to GIDL due to BTBT in SiGe devices.
US 2007/158770 A1 describes a lower cost range-finding image sensor based upon measurement of reflection time of light with reduced fabrication processes compared to standard CMOS manufacturing procedures. An oxide film is formed on a silicon substrate, and two photo-gate electrodes for charge-transfer are provided on the oxide film. Floating diffusion layers for taking charges out from a photodetector layer are provided at the ends of the oxide film, and on the outside thereof are provided a gate electrode for resetting and a diffusion layer for providing a reset voltage.
DE 10 2012/213280 A1 describes a backside illumination (BSI) image sensor pixel that includes microlenses with elevated refractive indices. The image sensor pixel may include a photodiode formed in a silicon substrate, a first microlens formed in a back surface of the substrate, a second microlens formed over a front surface of the substrate, a dielectric stack formed on the front surface of the substrate, and a reflective structure formed in the dielectric stack above the second microlens. The first microlens may be fabricated by forming shallow trench isolation structures in the back surface. The second microlens may be fabricated by depositing polysilicon on the front substrate of the substrate. The first microlens may serve to concentrate light towards the photo-diode, whereas the second microlens may serve to collimate light that traverses through the substrate so that light exiting the second microlens will reflect off the reflective structure and back into the photo-diode.
WO 96/39719 A1 describes a semiconductor substrate, suitable for epitaxial growth thereon, comprising a plurality of layers of material. The interfaces between layers act as reflectors of electromagnetic radiation. The reflectors may be used in, for example, resonant cavities in which may be located, for example, multi-quantum well detectors, the efficiency of said detectors being increased by virtue of the enhanced electric field associated with resonance in the cavity.

### SUMMARY

According to aspects of the present invention there is provided an imaging sensor array as defined in the accompanying claims.

The disclosed examples relate to an imaging sensory array being a sensor array applicable to time-of-flight (TOF) depth imaging. The imaging sensor array comprises an epitaxial germanium layer disposed on a silicon layer, and an electrically biased photoelectron collector arranged on the silicon layer, on a side opposite the germanium layer. Additional disclosed examples relate to a method of fabrication of the imaging sensor array and to a TOF depth-imaging camera employing the imaging sensor array.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

### BRIEF DESCRIPTION OF THE DRAWINGS

FIG. 1A illustrates an example method of fabricating an imaging sensor array.
FIG. 1B shows aspects of an example silicon-based, back-side illuminated time-of-flight sensor array through various stages of fabrication.
FIG. 2A illustrates modified and additional aspects of the method of FIG. 1A.
FIG. 2B shows aspects of an example germanium-modified, back-side illuminated time-of-flight sensor array through various stages of fabrication.
FIG. 3 shows aspects of an example graded silicon-germanium junction.
FIG. 4 shows aspects of photoelectron collection in an example germanium-modified, back-side illuminated time-of-flight sensor array.
FIG. 5 shows aspects of photoelectron collection in an example silicon-based, back-side illuminated time-of-flight sensor array.
FIG. 6 shows aspects of example germanium-modified, back-side illuminated time-of-flight sensor wafers in which a germanium EPI layer is selectively deposited under the pixel array.
FIG. 7 shows aspects of example germanium-modified, back-side illuminated time-of-flight sensor wafers in which a germanium EPI layer is selectively deposited in an area around the center of each pixel.
FIG. 8 shows aspects of an example depth imaging camera employing the imaging sensor array of FIG. 4.

### DETAILED DESCRIPTION

As noted above, terrestrial sunlight provides strong irradiance at and around 850 nm, where NIR optical sensors, including time-of-flight (TOF) sensors, often operate. The strong irradiance may correspond to a high background or noise level in the output from the optical sensor. One way to achieve an acceptable signal-to-noise (S / N) ratio, therefore, is to provide an emitter of relatively high power coupled operatively to the sensor. However, such an approach has various disadvantages, especially for optical systems that are battery-powered or intended to be used outdoors (where providing high enough emitter power may be impractical).

A different approach is to operate the optical-sensor somewhat deeper in the IR, where solar and other forms of ambient lighting contain less irradiance. Ideally, the operating point can be made to fall within one of the natural minima of the terrestrial insolation spectrum-e.g., in bands centered at 1130, 1380 or 1850 nm. Here the irradiance from sunlight is at least ten times less intense than at 850 nm. This approach, despite its advantages, also has disadvantages. In particular, the absorption coefficient of silicon (Si) falls sharply above 900 nm and is negligible at 1000 nm. Accordingly, the best-known semiconductor architecture of optical-sensor technology has poor response in the longer wavelength range.

In view of the foregoing issues, examples are disclosed that relate to an imaging sensor array having germanium (Ge) as the primary light absorbing element. The lower bandgap of germanium relative to silicon provides adequate absorptivity in the 1130 to 1600 nm range. The sensor is formed by growing an epitaxial (EPI) germanium layer on the back side of an Si-based TOF image-sensor wafer, which, after the completion of the BEOL process steps, has been bonded to a handling wafer, flipped, and thinned to a desired thickness. The germanium layer may be a planar layer of uniform thickness grown over the entire wafer, or it may be confined to just the pixel array or to an area within each pixel.

Additional aspects of this disclosure are now presented by way of example, and with reference to the drawing figures listed above. Components, process steps, and other elements that may be substantially the same in one or more of the figures are identified coordinately and are described with minimal repetition. It will be noted, however, that elements identified coordinately may also differ to some degree. It will be further noted that the figures are schematic and generally not drawn to scale. Rather, the various drawing scales, aspect ratios, and numbers of components shown in the figures may be purposely distorted to make certain features or relationships easier to see.

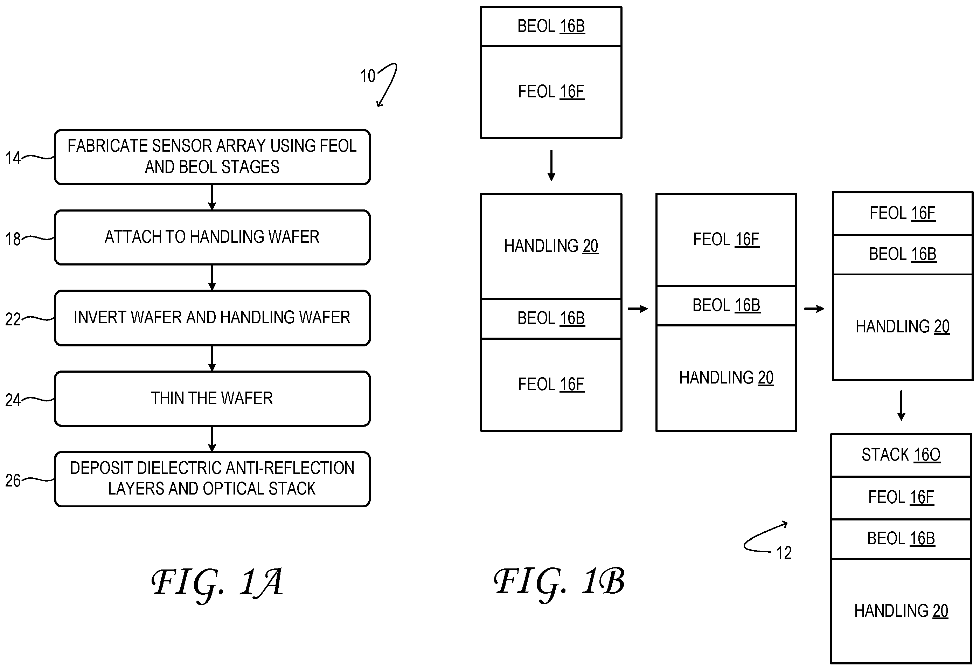

FIG. 1A illustrates an example method 10 for fabricating an imaging sensor array, such as a TOF sensor array. FIG 1B schematically shows the basic layer structure of the imaging sensor array in intermediate stages of the fabrication method. In one non-limiting example, method 10 may be used to form an Si-based, back side illuminated (BSI) TOF sensor array 12, starting with a conventionally prepared silicon wafer.

At 14 of method 10, a sensor array is fabricated on the wafer using a standard complementary metal-oxide-semiconductor (CMOS) process to pattern the wafer. The CMOS process comprises front-end-of-line (FEOL) and back-end-of-line (BEOL) stages, which form a structure having an FEOL (or silicon EPI) layer 16F and a BEOL layer 16B. In some examples, a photoelectron collector may be formed on the BEOL layer in the BEOL stage. In some examples, a metal contact may be arranged on the BEOL layer of the patterned wafer.

At 18, after completion of the BEOL stage, the patterned silicon wafer is attached to a handling wafer 20, to facilitate wafer transport and manipulation. The handling wafer 20 may also be a CMOS wafer containing circuitry that may be electrically coupled to the patterned wafer 16. At 22, the patterned silicon wafer and handling wafer are inverted for additional back-side processing. The additional back-side processing involves, at 24, thinning the patterned silicon wafer from the FEOL face, from about 800 µm down to < 10 µm. A combination of chemical mechanical polishing (CMP) and wet etching, for example, may be used to enact the thinning. In examples where the desired product is an Si-based imaging sensor array 12, the final thickness of the silicon EPI layer of the wafer may fall between 6 and 10 µm. In other examples, to be described hereinafter, the final thickness of the silicon EPI layer may be less than 6 µm-*e.g.*, 2 to 3 µm. In general, the desired final thickness of the silicon EPI layer may be determined as a trade-off between sensitivity and modulation contrast (*vide infra*)*.* In the example shown in FIG. 1B, after thinning the wafer to its final thickness, an optical stack 16O comprising one or more dielectric anti-reflection layers, at 26, are deposited. Optionally, the dielectric anti-reflection layers may be followed by a micro-lens array to yield conventional Si-based TOF sensor array 12.

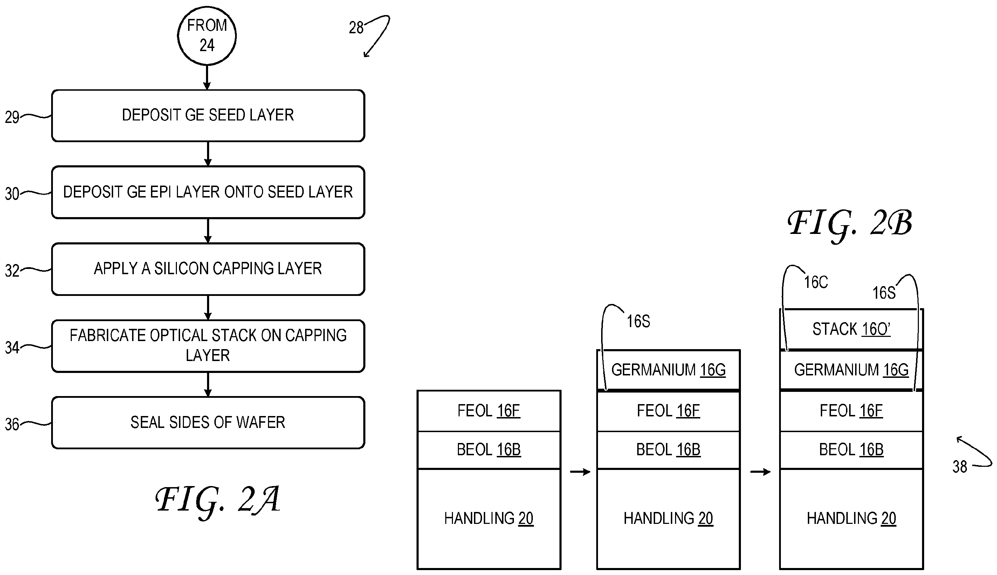

FIG. 2A illustrates various modified and additional steps 28 of example fabrication method 10. The modifications and additions presented in FIG. 2A result in an imaging sensor array having significantly extended wavelength response. FIG 2B schematically shows the basic layer structure of the modified imaging sensor array at intermediate stages of the fabrication method. At 29 of method 10 (as an alternative to 26 of FIG. 1A) a thin epitaxial seed layer 16S of germanium is applied to exposed FEOL layer 16F. The seed layer may be about 20 angstrom units thick, in some examples. Chemical vapor deposition (CVD) or any other suitable method may be used to lay down the seed layer. In some examples, deposition of the seed layer may be plasma-enhanced. In some examples, deposition of the seed layer is conducted at a temperature not to exceed 410 °C. More generally, the deposition temperature may be determined by the limit beyond which metal lines or other BEOL elements would be subjected to thermal-related stresses, which may result in sensor failure. Examples of relevant failure modes include electromigration and stress migration of copper, which may occur at temperatures greater than approximately 410 °C.

Seed layer 16S may help to ensure that the crystal structure across the transition from silicon EPI layer 16F to a germanium adlayer (*vide infra*) has a suitably low defect density. At 30, accordingly, following application of the seed layer, a thicker germanium EPI layer 16G is deposited onto seed layer 16S. The germanium EPI layer may be applied using CVD or any other suitable method, to yield a silicon-germanium hybrid structure. The overall thickness of germanium EPI layer 16G is determined so as to provide the desired quantum efficiency for photoelectron collection and fast electron transport, as described further below.

At 32, after the desired thickness of germanium, ranging from 0.5 to 1.0 µm in some examples, is deposited, the germanium EPI layer 16G may be capped with a thin capping layer 16C of silicon. The capping layer may range from a few nanometers to tens of nanometers. The capping layer may serve to protect the germanium EPI layer and to form a base for subsequent deposition of silicon-based dielectric layers that form the optical stack. At 34, accordingly, an optical stack 16O' is fabricated on top of the thin silicon capping layer 16C. These features are set down as part of a modified BSI process.

One concern regarding deposition of material on the back side of a thinned CMOS wafer is the possibility of contamination of the deposition chamber with ions from the metal lines applied to the BEOL layer, which lie exposed on the edge of the wafer. Accordingly, the sides of the wafer may be sealed, at 36, with an oxide or with any other suitable material that serves as a barrier against metal ion diffusion. The resulting Ge-modified hybrid imaging sensor array is shown at 38.

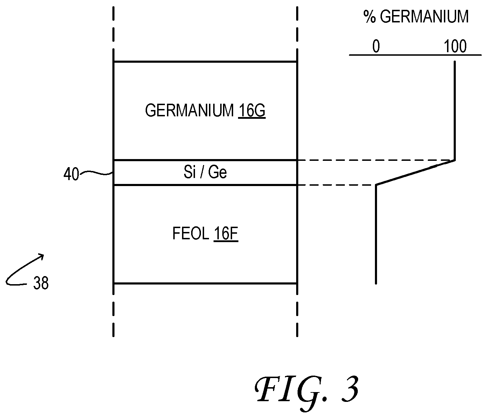

The fabrication described above in the context of FIG. 2A results in an abrupt Si-Ge junction between layers 16F and 16G. In other examples, the germanium composition may be varied gradually-e.g., from zero at the boundary of FEOL layer 16F to 100 percent at the boundary of germanium EPI layer 16G. The material gradation may be realized over a very short distance-e.g., 100 nanometers. This variant results in a graded transition layer 40, as shown in FIG. 3.

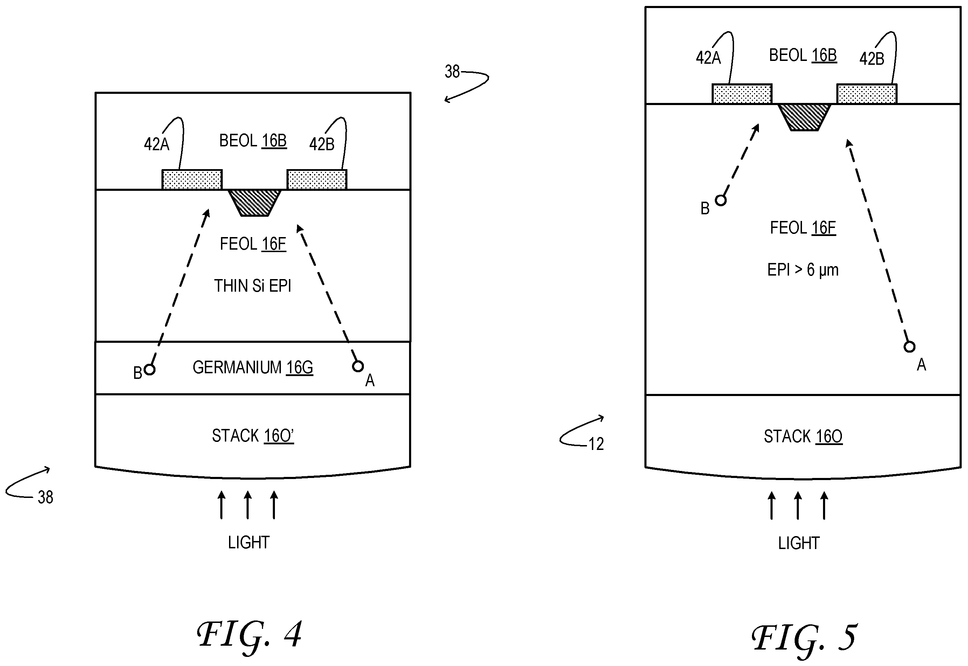

FIG. 4 shows germanium EPI layer 16G of imaging sensor array 38, which is disposed on a silicon FEOL layer 16F. The germanium EPI layer may be configured to absorb the majority of the shorter-wavelength light- *i.e.,* λ ≤ 1000 nm, before such light interacts with Si-and a substantial portion of longer-wavelength light, λ > 1000 nm, with silicon absorbing what remains for λ ≤ 1000 nm. Silicon, by contrast, is very weakly absorbing beyond 1000 nm. Accordingly, whatever photoelectrons are generated in response to light of λ > 1000 nm are generated in the germanium EPI layer.

FIG. 4 also shows an electrically biased photoelectron collector arranged in silicon BEOL layer 16B, on a side of FEOL layer 16F opposite germanium EPI layer 16G. The imaging sensor array 38 is a time-of-flight sensor array, wherein the photoelectron collector includes first and second polyfinger electrodes 42A and 42B. The electrical bias applied to the first polyfinger electrode is shifted in phase with respect to the electrical bias applied to the second polyfinger electrode. The phase shift may be 180°, for example. In this configuration, photoelectrons generated by absorption of light are injected from germanium layer 16G into silicon layer 16F and move toward one or the other of the independently clocked polyfinger electrodes 42. The polyfinger electrodes serve as gates, driving the photoelectrons along an electrostatic potential gradient resulting from the electrical bias applied to the polyfingers. The distance that the injected electrons must travel to reach the polyfingers is nearly equal to the thickness of the silicon EPI; the time taken to do so is referred to as the transit time tₑ. As described in further detail below, the tₑ value affects the modulation contrast (MC) of the TOF sensor array, especially at higher frequencies.

A suitably high modulation contrast (MC) improves the jitter and power performance of a TOF array by improving the signal-to-noise ratio, and an increase in frequency reduces the distance to modulation-phase ratio, which also reduces jitter and power dissipation. In sum, the shorter the tₑ, the higher the MC, especially at high frequencies. In imaging sensor array 38, a suitably high MC is achieved at high frequencies by optimally positioning the germanium EPI layer with respect to the polyfingers-i.e., by optimally setting the silicon EPI thickness, and thereby reducing tₑ.

On the other hand, if the transit time tₑ is comparable to or longer than half the period T (1 / 2 × frequency) of the clock signal on the polyfinger electrodes, then the MC may be severely degraded. Thus, a low tₑ facilitates high frequency operation. This can be achieved by (a) reducing the distance that the electrons must travel to the polyfinger electrodes, (b) increasing the mobility of the electrons within the semiconductor, and/or (c) increasing the vertical electric field strength. Of the three, the first may be achieved by reducing the thickness of the absorption layer. With silicon, however, this tactic may reduce the quantum efficiency in the IR region. In state-of-the-art TOF detectors, for instance, a relatively thick (> 6 µm) layer of silicon is required for adequate absorbance, due to the low absorption coefficient of silicon in the infrared. However, this feature also increases tₑ for electrons generated deep in the EPI layer (farthest from the gate). This effect is illustrated in the conventional Si-based imaging sensor array of FIG. 5, where the photoelectron generated at A takes longer to reach polyfingers 42, as compared to the photoelectron generated at B. Consequently, MC degrades in the configuration of FIG. 5 as the operational frequency of the sensor increases, such that operation beyond 400 MHz is challenging.

By contrast, tₑ is relatively short for the sensors proposed according to method 2A, as the light absorption occurs substantially in the germanium layer. The photoelectrons diffuse through this layer and are injected across the Ge-Si interface and into the silicon EPI, as shown in FIG. 4. Moreover, the silicon EPI, being substantially thinner than that of a conventional TOF pixel, maintains a higher electric field for the same voltage applied to the polyfinger electrodes. This feature may result in a higher electron velocity. In sum, the short distance that the injected electrons must travel to the polyfingers combined with their higher velocity results in a short tₑ. The MC may remain high, therefore, even at an operational frequency of 1 GHz.

The factors described above may be affected, to some degree, by doping. In some examples, the germanium EPI layer is p-doped at such concentration as to align the conduction bands of silicon and germanium to achieve substantially complete injection of electrons transported from within the germanium EPI layer to an interface between the silicon and germanium EPI layers. In these and other examples, the germanium EPI layer may be p-doped at such concentration as to prolong the lifetime of photoelectrons generated in the germanium EPI layer, to allow diffusion to an interface between the silicon and germanium EPI layers.

The desired thickness of germanium EPI layer 16G is determined by the opposing advantages of maximizing absorption (viz., the optical absorption path length) and enabling fast electron diffusion towards the Ge-Si interface, and further influenced by the desire to suppress dark current (*vide infra*)*.* In the expected mode of operation, the germanium EPI layer supports little or no electric field. Therefore, electron transport across the germanium EPI layer is dominated by diffusion. Since diffusion is slow relative to drift, the use of a relatively thinner germanium layer may help to achieve a short tₑ.

Dark current is larger for Ge-based photodetectors than for Si-based, owing to the much smaller band gap of germanium relative to Si. Moreover, state-of-the-art germanium-based photodetectors based on depleted p-n or p-i-n junctions exhibit much higher dark current for several additional reasons. First, these junctions have a more extensive depletion region, which maximizes the thermal generation volume and enhances leakage effects-*e.g.,* trap assisted tunneling (TAT). Second, ohmic contacts are typically fabricated directly onto the p- and n- regions, which cause leakage due to contact-etch damage. Third, in lateral diodes, the p-n or p-i-n junctions are in contact with the gate dielectric or with a passivating oxide layer, which enhances the generation-recombination (G-R) rate at the interface.

However, the configuration of imaging sensor array 38 may avoid excessive dark current by averting the above contributory factors. In particular, both the electric field in the germanium EPI layer and the extent of the depletion region are reduced. First, the germanium EPI layer may be deposited as a planar layer with either uniform p-doping or a very small doping gradient. In the latter case, the gradient may be so small that the associated electric field is negligible, so effects associated with high electric fields, such as enhanced carrier generation due to TAT, may be absent. In other words, the germanium EPI layer may be p-doped with a gradient, so as to impart an electric field low enough to avoid trap-assisted tunneling (TAT) but adequate to provide driving force to photoelectrons generated within the germanium EPI layer to drift to an interface between the silicon and germanium EPI layers. Second, since there are no p-n junctions in or near the germanium EPI layer, there may be no large depletion regions within it, where thermal generation may contribute to the dark current. Thus, the germanium EPI layer may be p-doped and such concentration as to reduce a depletion region width at an interface between the silicon and germanium EPI layers, and thereby suppress thermal generation of electrons across the interface. A third feature is that the germanium EPI layer, on the one side interfaces with the silicon EPI, and on the other, is passivated by a thin silicon EPI layer. In some implementations, however, a thicker silicon EPI may be used. In effect, the germanium EPI layer is a buried layer-in contrast to conventional lateral p-n junction-based detectors, where the junction extends to the surface. A buried layer may have comparatively fewer defects due to the absence of surface states and therefore a lower dark current generation rate.

Operationally, a differential TOF-sensor pixel of imaging sensor array 38 may be more immune to problematic dark currents than in the pixels of an RGB camera, for the following additional reasons. First, the integration times may be one or two orders of magnitude smaller than in a conventional imaging pixel. The dark current generated in this short period also may be correspondingly smaller. Thus, the problems associated with a higher dark current are mitigated by the shorter integration time. Second, the proposed pixel operates in a differential mode-*i.e.*, the meaningful signal is the difference between the signals (charge collected) from the individual polyfingers. Accordingly, the dark current collected by the two gates may cancel in difference. The only surviving component of dark current in imaging sensor array 38, in effect, is the shot noise from the dark current collected by the polyfingers. This also may be reduced by optimizing the doping of the germanium EPI layer. In some examples, therefore, the germanium EPI layer may be p-doped at such concentration as to reduce a minority-carrier electron concentration in the germanium EPI layer to a level at which dark current in the imaging sensor array is minimized.

Dark current generation in germanium may also be reduced by decreasing the amount of germanium used in each pixel, as described hereinafter. To preserve high quantum efficiency, various light shaping structures may be used at the backside of the pixel to cause the incident light to be trapped within the pixel by total internal reflection. As a result, light can traverse the germanium EPI layer multiple times, thereby increasing absorption. Furthermore, microlenses may be used to focus the light to a smaller spot size, thereby reducing the size of the required germanium portion.

As noted above, one method of incorporating the germanium EPI includes depositing a blanket layer of germanium on the backside of a completed CMOS camera wafer that has been thinned to a specific thickness. More generally, however, the imaging sensor array may be arranged on a semiconductor wafer with sensor-addressing circuitry fabricated thereon, and the germanium EPI layer may be spaced apart from the sensor-addressing circuitry. Thus, the detailed implementation of the method of FIG. 2A may include masking to limit growth of germanium to within boundaries of the pixel array or to boundaries within a portion of individual pixels in the imaging sensor array.

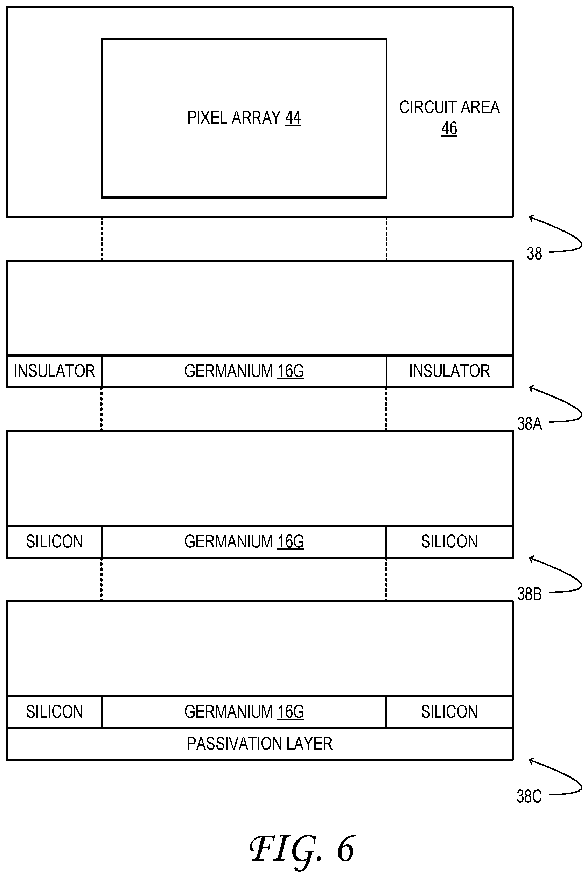

In the example shown in FIG. 6, germanium EPI layer 16G may be selectively deposited under pixel array 44, and not under the analog and digital circuit area 46. This architecture, shown at 38A, may have the added advantage of avoiding the introduction of noise in the circuitry, since light of λ > 1000 nm incident directly on or straying into the area does not generate electron-hole pairs capable of being collected by the diffusion regions. It will be noted that it is not only direct illumination that is of concern (which may be avoided by shielding), but also light that is conveyed by total internal reflections from the pixel area to the circuit area. In related example 38B, another material, such as silicon is deposited below circuit area 46. In related example 38C, an additional passivation layer (Si) is applied below the Ge / Si mixed layer.

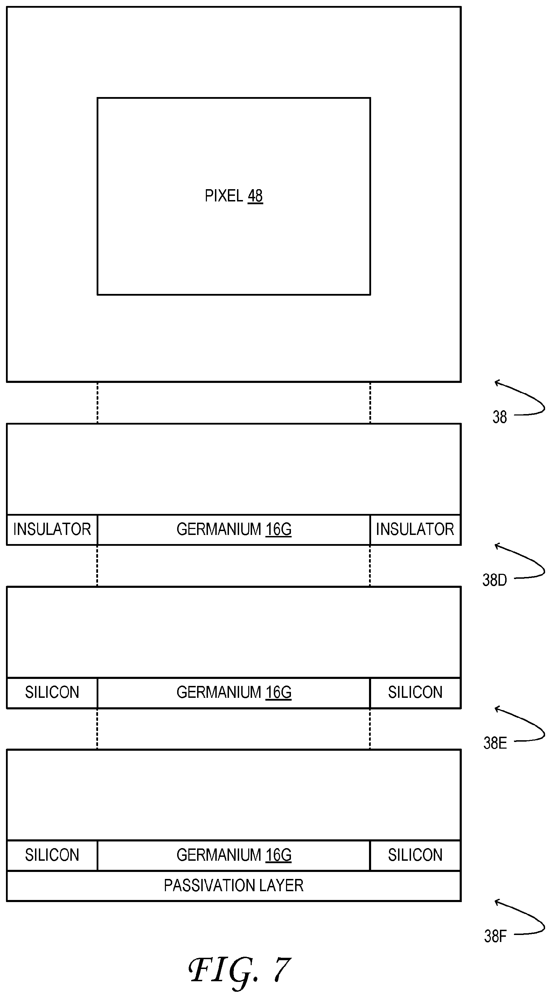

In still other examples, as shown in FIG. 7, a germanium EPI layer 16G may be selectively deposited in an area around the center of the pixel 48 and surrounded by oxide, by silicon, or by other materials. Thus, the detailed implementation of the method of FIG. 2A may include masking to limit growth of germanium to within boundaries of the pixel array or to boundaries within a portion of individual pixels in the imaging sensor array and growing a layer of another semiconductor or any other material as a capping layer. In example 38D, the germanium EPI layer is selectively formed at plurality of pixel portions of the imaging sensor array, with an insulator or a semiconductor (e.g., Si, as illustrated in examples 38E and 38F) separating the germanium between the pixel portions. In some examples, the portion of the pixel area covered by the germanium EPI layer may be smaller than the actual pixel area. Since the germanium EPI layer is confined to a small region within the pixel area, it may be free of stresses and defects that could enhance generation-recombination rates.

In some examples, the very low absorbance of silicon to the wavelengths greater than 1000 nm (where germanium is excited) may be used to an advantage. For instance, the optical stack and microlens array 16O' applied to the germanium EPI layer may comprise epitaxial silicon, in whole or in part. This additional silicon EPI layer may be patterned and/or etched to any desired profile, including profiles configured to provide optical (*i.e.,* focusing) power. Such profiles, when formed in silicon (with a refractive index *n* ≈ 3.98) may require very little curvature to achieve significant optical power. As a result, an optical stack comprising elemental silicon may be much thinner than a functionally equivalent stack comprising conventional optical materials (*e.g.,* silica glass at *n* ≈ 1.46). In one example, a silicon microlens array applied over the germanium EPI layer may be used to focus light on the individual pixel elements of the array.

In other examples, the silicon wafer itself may be patterned and/or etched to provide a desired optical effect optically downstream of the germanium EPI layer. In particular, light that has already passed through the germanium EPI layer but was not absorbed (due to the thinness of the layer) may be redirected back through the germanium EPI layer and focused on the appropriate Ge-containing pixel area. In some examples, this and other forms of optical structure fabrication may be applied to both the front and back of the sensor array, so that the image light makes multiple passes through the germanium EPI layer until it is eventually absorbed, in a cavity ring-down manner. This strategy may be used to improve quantum efficiency in very thin germanium EPI layers (advantageous for the reasons discussed above).

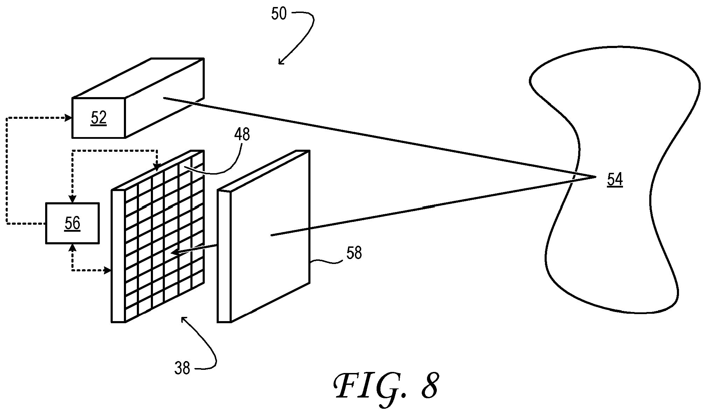

FIG. 8 schematically shows aspects of an example time-of-flight depth camera 50 that incorporates imaging sensor array 38. The depth camera includes an emitter 52 configured to irradiate subject 54 with modulated light-sinusoidally modulated, pulse modulated, or modulated according to any other periodic waveform. In a more particular embodiment, the emitter may be a programmable near-infrared laser capable of emitting in a continuous-modulation mode or in a repeating-burst mode. Continuing in FIG. 8, some modulated light from the emitter reflects back from the subject to imaging sensor array 38, which includes an array of sensor elements 48. Because the light pulses received at the photodetector array have traveled out to the subject and back, they differ in phase from the pulse train released by the emitter. The phase difference varies (e.g., increases) in proportion to the distance the subject is from the depth camera, but wraps upon reaching a 2π radian phase shift. By determining the phase shift for each pixel of the array, a depth map of the imaged subject can be computed. Driver 56 provides synchronized drive signals to the emitter and to the array for the purpose of determining the phase shift. In examples in which each sensor element of the imaging sensor array includes a pair of polyfinger electrodes (not shown in FIG. 8), those electrodes may be driven out of phase from each other by 180°. Alternative drive modes are also envisaged.

To provide some measure of ambient-light rejection, imaging sensor array 38 is arranged behind an optical band-pass filter 58. In this arrangement, the pixels of the imaging sensor array are substantially insensitive to light outside the passband of the filter. Preferably, the passband is chosen to match the emission wavelength band of emitter 52. In one embodiment, the emitter may be a narrow-band infrared (IR) emitter such as an IR laser or IR light-emitting diode (LED). Irradiance and photo-detection in the IR provides an additional advantage in that a human subject will not detect the irradiance from the emitter. In some examples, the passband of the filter may be set to greater than 1000 nm for the reasons described hereinabove. Accordingly, the passband filter may be configured to transmit at least some wavelengths longer than one micron and to block wavelengths shorter than one micron. In some examples, the passband filter may include a notch filter. In other examples, the passband filter may include a high-pass filter (as defined in terms of wavelength).

With respect to the pulsed output of emitter 52, this disclosure embraces a broad range of output power and modulation pulse width. In one non-limiting embodiment, the pulse width may be about one half of the reciprocal of the modulation frequency. Along with the output power, the modulation frequency appropriate for a given depth-sensing application depends on the distance between subject 54 and depth camera 50. For distances on the order of three meters, each modulation cycle of the emitter may be 20 nanoseconds (ns); the ON pulse width within that modulation cycle may be about 10 ns, for a 50% duty cycle. It will be noted, however, that other ranges and modulation frequencies are fully consistent with this disclosure.

## Claims

1. An imaging sensor array (38) wherein the imaging sensor array is a time-of-flight sensor array, the imaging sensor array comprising:
an electrically biased photoelectron collector (42A, 42B) formed on a silicon transport layer (16F);
an epitaxial germanium layer (16G) grown on the silicon transport layer, on a side opposite the photoelectron collector;
**characterized in that** the imaging sensor array comprises
a silicon passivation layer grown on the epitaxial germanium layer, on a side opposite the silicon transport layer, and **in that**
the photoelectron collector includes first (42A) and second electrodes (42B), and wherein electrical bias applied to the first electrode is configured to shift in phase with respect to electrical bias applied to the second electrode.

2. The imaging sensor array of claim 1 wherein the imaging sensor array is arranged on a semiconductor wafer (16) with sensor-addressing circuitry fabricated thereon, and wherein the epitaxial germanium layer is spaced apart from the sensor-addressing circuitry in a thickness direction.

3. The imaging sensor array of claim 1 wherein the epitaxial germanium layer is selectively formed at a plurality of pixel portions of the imaging sensor array, and wherein an insulator or semiconductor separates the epitaxial germanium between the pixel portions.

4. The imaging sensor array of claim 1 wherein the epitaxial germanium layer is bonded to the silicon transport layer via a material gradation whereby the germanium composition is varied gradually.

5. The imaging sensor array of claim 1 wherein the epitaxial germanium layer is p-doped at such concentration as to align the conduction bands of silicon and germanium to achieve complete injection of electrons transported from within the epitaxial germanium layer to an interface between the silicon transport and epitaxial germanium layers.

6. The imaging sensor array of claim 1 wherein the epitaxial germanium layer is p-doped at such concentration as to reduce a minority-carrier electron concentration in the epitaxial germanium layer to a level at which dark current in the imaging sensor array is minimized.

7. The imaging sensor array of claim 1 wherein the epitaxial germanium layer is p-doped at such concentration as to reduce a depletion region width at an interface between the silicon transport and epitaxial germanium layers, and thereby suppress thermal generation of electrons across the interface, from an original depletion region width at the interface between the silicon transport and epitaxial germanium layers that does not suppress thermal generation of electrons across the interface.

8. The imaging sensor array of claim 1 wherein the epitaxial germanium layer is p-doped with a gradient, so as to impart an electric field low enough to avoid trap-assisted tunneling, while providing driving force to photoelectrons generated within the epitaxial germanium layer to drift to an interface between the silicon transport and epitaxial germanium layers.

9. The imaging sensor array of claim 1 wherein the first and second electrodes are polyfinger electrodes.

10. The imaging sensor array of claim 1, further comprising one or both of a microlens array and an anti-reflection layer.

11. The imaging sensor array of claim 1, further comprising a microlens array based on elemental silicon as a refractive medium.

12. The imaging sensor array of claim 1 further comprising a structure configured to promote cavity ring-down absorption in the epitaxial germanium layer so that light admitted to the epitaxial germanium layer makes multiple passes through the epitaxial germanium layer via internal reflection.

13. The imaging sensor array of claim 1, further comprising a light-shaping structure formed on the photoelectron collector, on the side opposite the epitaxial germanium layer, the light-shaping structure being configured to cause light incident on the epitaxial germanium layer to reflect repeatedly through the epitaxial germanium layer by total internal reflection, thereby increasing absorption.

14. A camera (50) comprising:
an imaging sensor array as defined in any preceding claim, wherein the silicon transport layer is 3 microns or less in thickness, and the epitaxial germanium layer is 0.5 to 1 micron in thickness; and
arranged between the imaging sensor array and a photographic subject (54), a passband filter (58) configured to transmit at least some wavelengths longer than one micron and to block wavelengths shorter than one micron.

15. The camera of claim 14, further comprising a modulated emitter (52) and a controller (56) configured to address the imaging sensor array in synchronicity with the modulated emitter.

## Patentansprüche

1. Bildgebende Sensoranordnung (38), wobei die bildgebende Sensoranordnung eine Lichtlaufzeitsensoranordnung ist und die bildgebende Sensoranordnung Folgendes umfasst:
einen elektrisch vorgespannten Photoelektronenkollektor (42A, 42B), der auf einer Siliziumtransportschicht (16F) gebildet ist;
eine epitaxiale Germaniumschicht (16G), die auf der Siliziumtransportschicht auf einer Seite gegenüber dem Photoelektronenkollektor gezüchtet ist;
**dadurch gekennzeichnet, dass** die bildgebende Sensoranordnung eine Siliziumpassivierungsschicht umfasst, die auf einer Seite gegenüber der Siliziumtransportschicht auf der epitaxialen Germaniumschicht gezüchtet ist, und dadurch, dass der Photoelektronenkollektor eine erste (42A) und eine zweite Elektrode (42B) beinhaltet, und wobei die elektrische Vorspannung, die an die erste Elektrode angelegt ist, dazu konfiguriert ist, sich in Bezug auf die elektrische Vorspannung, die an die zweite Elektrode angelegt ist, in der Phase zu verschieben.

2. Bildgebende Sensoranordnung nach Anspruch 1, wobei die bildgebende Sensoranordnung auf einem Halbleiterwafer (16) angeordnet ist, der eine darauf gefertigte Sensoradressierungsschaltung aufweist, und wobei die epitaxiale Germaniumschicht in einer Dickerichtung von der Sensoradressierungsschaltung beabstandet ist.

3. Bildgebende Sensoranordnung nach Anspruch 1, wobei die epitaxiale Germaniumschicht selektiv bei einer Vielzahl von Pixelabschnitten der bildgebenden Sensoranordnung gebildet ist und wobei ein Isolator oder ein Halbleiter das epitaxiale Germanium zwischen den Pixelabschnitten trennt.

4. Bildgebende Sensoranordnung nach Anspruch 1, wobei die epitaxiale Germaniumschicht über eine Materialabstufung an die Siliziumtransportschicht gebunden ist, wobei die Germaniumzusammensetzung schrittweise variiert wird.

5. Bildgebende Sensoranordnung nach Anspruch 1, wobei die epitaxiale Germaniumschicht mit einer derartigen Konzentration p-dotiert ist, dass die Leitungsbänder des Siliziums und des Germaniums ausgerichtet sind, um eine vollständige Injektion von Elektronen, die von innerhalb der epitaxialen Germaniumschicht zu einer Schnittstelle zwischen der Siliziumtransport- und der epitaxialen Germaniumschicht transportiert werden, zu erreichen.

6. Bildgebende Sensoranordnung nach Anspruch 1, wobei die epitaxiale Germaniumschicht mit einer derartigen Konzentration p-dotiert ist, dass eine Minoritätsträger-Elektronenkonzentration in der epitaxialen Germaniumschicht auf ein Niveau reduziert wird, bei dem Dunkelstrom in der bildgebenden Sensoranordnung minimiert wird.

7. Bildgebende Sensoranordnung nach Anspruch 1, wobei die epitaxiale Germaniumschicht mit einer derartigen Konzentration p-dotiert ist, dass eine Verarmungszonenbreite bei einer Schnittstelle zwischen der Siliziumtransport- und der epitaxialen Germaniumschicht reduziert wird und somit thermische Erzeugung von Elektronen von einer ursprünglichen Verarmungszonenbreite bei der Schnittstelle zwischen der Siliziumtransport- und der epitaxialen Germaniumschicht, die thermische Erzeugung von Elektronen über der Schnittstelle nicht unterdrückt, über der Schnittstelle unterdrückt wird.

8. Bildgebende Sensoranordnung nach Anspruch 1, wobei die epitaxiale Germaniumschicht mit einem Gradienten p-dotiert ist, um ein elektrisches Feld zu erzeugen, dass gering genug ist, um störstellenunterstütztes Tunneln zu vermeiden, während Photoelektronen, die innerhalb der epitaxialen Germaniumschicht erzeugt werden, eine Antriebskraft bereitgestellt wird, um zu einer Schnittstelle zwischen der Siliziumtransport- und der epitaxialen Germaniumschicht zu driften.

9. Bildgebende Sensoranordnung nach Anspruch 1, wobei die erste und die zweite Elektrode Kammelektroden sind.

10. Bildgebende Sensoranordnung nach Anspruch 1, ferner umfassend eines oder beides von einer Mikrolinsenanordnung und einer Antireflexionsschicht.

11. Bildgebende Sensoranordnung nach Anspruch 1, ferner umfassend eine Mikrolinsenanordnung, die auf elementarem Silizium als Brechungsmedium basiert.

12. Bildgebende Sensoranordnung nach Anspruch 1, ferner umfassend eine Struktur, die dazu konfiguriert ist, Cavity-Ring-Down-Absorption in der epitaxialen Germaniumschicht zu fördern, sodass Licht, das in die epitaxiale Germaniumschicht eingelassen wird, die epitaxiale Germaniumschicht über interne Reflexion mehrmals durchläuft.

13. Bildgebende Sensoranordnung nach Anspruch 1, ferner umfassend eine lichtformende Struktur, die auf der Seite gegenüber der epitaxialen Germaniumschicht an dem Photoelektronenkollektor gebildet ist, wobei die lichtformende Struktur dazu konfiguriert ist, zu bewirken, dass Licht, das auf die epitaxiale Germaniumschicht trifft, durch totale interne Reflexion wiederholt durch die epitaxiale Germaniumschicht reflektiert wird, und dadurch die Absorption erhöht.

14. Kamera (50) umfassend:
eine bildgebende Sensoranordnung nach einem vorhergehenden Anspruch, wobei die Siliziumtransportschicht eine Dicke von 3 Mikrometern oder weniger aufweist und die epitaxiale Germaniumschicht eine Dicke von 0,5 bis 1 Mikrometer aufweist; und
ein Bandpassfilter (58), das zwischen der bildgebenden Sensoranordnung und einem fotografischen Motiv (54) angeordnet und dazu konfiguriert ist, mindestens einige Wellenlängen, die länger als ein Mikrometer sind, durchzulassen und Wellenlängen, die kürzer als ein Mikrometer sind, zu blockieren.

15. Kamera nach Anspruch 14, ferner umfassend einen modulierten Emitter (52) und eine Steuerung (56), die dazu konfiguriert ist, die bildgebende Sensoranordnung synchron mit dem modulierten Emitter anzusteuern.

## Revendications

1. Réseau de capteurs d'imagerie (38) dans lequel le réseau de capteurs d'imagerie est un réseau de capteurs de temps de vol, le réseau de capteurs d'imagerie comprenant :
un collecteur de photoélectrons polarisé électriquement (42A, 42B) formé sur une couche de transport en silicium (16F) ;
une couche de germanium en épitaxie (16G) développée sur la couche de transport en silicium, sur un côté opposé au collecteur de photoélectrons ;
**caractérisé en ce que** le réseau de capteurs d'imagerie comprend
une couche de passivation en silicium développée sur la couche de germanium en épitaxie, sur un côté opposé à la couche de transport en silicium, et **en ce que**
le collecteur de photoélectrons comporte des première (42A) et seconde électrodes (42B), et dans lequel la polarisation électrique appliquée à la première électrode est configurée pour se déphaser par rapport à la polarisation électrique appliquée à la seconde électrode.

2. Réseau de capteurs d'imagerie selon la revendication 1, dans lequel le réseau de capteurs d'imagerie est disposé sur une plaquette de semi-conducteur (16) avec un circuit d'adressage de capteur fabriqué sur celle-ci, et dans lequel la couche de germanium en épitaxie est espacée du circuit d'adressage de capteur dans une direction d'épaisseur.

3. Réseau de capteurs d'imagerie selon la revendication 1, dans lequel la couche de germanium en épitaxie est formée sélectivement au niveau d'une pluralité de portions de pixels du réseau de capteurs d'imagerie, et dans lequel un isolant ou un semi-conducteur sépare le germanium en épitaxie entre les portions de pixels.

4. Réseau de capteurs d'imagerie selon la revendication 1, dans lequel la couche de germanium en épitaxie est liée à la couche de transport en silicium via une gradation de matériau par lequel la composition de germanium est variée progressivement.

5. Réseau de capteurs d'imagerie selon la revendication 1, dans lequel la couche de germanium en épitaxie est dopée p à une concentration telle qu'elle aligne les bandes de conduction de silicium et de germanium pour obtenir une injection complète des électrons transportés de l'intérieur de la couche de germanium en épitaxie vers une interface entre les couches de transport de silicium et de germanium en épitaxie.

6. Réseau de capteurs d'imagerie selon la revendication 1, dans lequel la couche de germanium en épitaxie est dopée p à une concentration telle qu'elle réduit une concentration d'électrons porteurs minoritaires dans la couche de germanium en épitaxie à un niveau où le courant d'obscurité dans le réseau de capteurs d'imagerie est minimisé.

7. Réseau de capteurs d'imagerie selon la revendication 1, dans lequel la couche de germanium en épitaxie est dopée p à une concentration telle qu'elle réduit une largeur de zone de déplétion au niveau d'une interface entre les couches de transport en silicium et de germanium en épitaxie, et ainsi supprime la génération thermique d'électrons à travers l'interface, à partir d'une largeur de zone de déplétion initiale au niveau de l'interface entre les couches de transport en silicium et de germanium en épitaxie qui ne supprime pas la génération thermique d'électrons à travers l'interface.

8. Réseau de capteurs d'imagerie selon la revendication 1, dans lequel la couche de germanium en épitaxie est dopée p avec un gradient, de manière à conférer un champ électrique suffisamment faible pour éviter l'effet tunnel assisté par piège, tout en fournissant une force conductrice aux photoélectrons générés dans la couche de germanium en épitaxie pour dériver vers une interface entre les couches de transport en silicium et de germanium en épitaxie.

9. Réseau de capteurs d'imagerie selon la revendication 1, dans lequel les premier et second électrodes sont des électrodes à doigts multiples.

10. Réseau de capteurs d'imagerie selon la revendication 1, comprenant en outre l'un des éléments suivants ou les deux : un réseau de microlentilles et une couche anti-reflet.

11. Réseau de capteurs d'imagerie selon la revendication 1, comprenant en outre un réseau de microlentilles sur la base de silicium élémentaire comme support réfractif.

12. Réseau de capteurs d'imagerie selon la revendication 1, comprenant en outre une structure configurée pour favoriser l'absorption par résonance de cavité dans la couche de germanium en épitaxie de sorte que la lumière admise dans la couche de germanium en épitaxie effectue plusieurs passages à travers la couche de germanium en épitaxie via réflexion interne.

13. Réseau de capteurs d'imagerie selon la revendication 1, comprenant en outre une structure de mise en forme de lumière formée sur le collecteur de photoélectrons, sur le côté opposé à la couche de germanium en épitaxie, la structure de mise en forme de lumière étant configurée pour amener un incident lumineux sur la couche de germanium en épitaxie à réfléchir à plusieurs reprises à travers la couche de germanium en épitaxie par réflexion interne totale, augmentant ainsi l'absorption.

14. Caméra (50), comprenant :
un réseau de capteurs d'imagerie tel que défini dans une quelconque revendication précédente, dans lequel la couche de transport en silicium a une épaisseur de 3 microns ou moins, et la couche de germanium en épitaxie a une épaisseur de 0,5 à 1 micron ; et
disposé entre le réseau de capteurs d'imagerie et un sujet photographique (54), un filtre passe-bande (58) configuré pour transmettre au moins certaines longueurs d'onde supérieures à un micron et pour bloquer les longueurs d'onde inférieures à un micron.

15. Caméra selon la revendication 14, comprenant en outre un émetteur modulé (52) et un dispositif de commande (56) configuré pour adresser le réseau de capteurs d'imagerie en synchronisation avec l'émetteur modulé.
